# EUROPEAN PATENT APPLICATION

(11) **EP 1 641 322 A1**
(43) Date of publication of application: **29.03.2006**
(21) Application number: 04723083.4
(22) Date of filing: 24.03.2004
(51) Int. Cl.: H05B 33/02

(54) **EL DEVICE, PROCESS FOR MANUFACTURING THE SAME, AND LIQUID CRYSTAL DISPLAY EMPLOYING EL DEVICE**

(30) Priority: 13.06.2003 JP 2003169503
(71) Applicant: Toyota Industries Corporation, Aichi-ken, 448-8671 (JP)
(72) Inventor: FUNADA, Mari, a-cho; Kariya-shi, Aichi 4488671 (JP); KATO, Yoshifumi, a-cho; Kariya-shi, Aichi 4488671 (JP); ITO, Hironori, a-cho; Kariya-shi, Aichi 4488671 (JP); TAKEUCHI, Norihito, Kariya-shi, Aichi 4488671 (JP); UTSUMI, Tetsuya, (JP)
(74) Representative: TBK-Patent
(86) International application number: PCT/JP2004/004130
(87) International publication number: WO 2004/112434

(57) **Abstract**

After entering a transparent substrate 9 of an organic EL device and passing through this substrate 9, an outside light L1 further passes through a transparent layer 10, a transparent electrode 12, and an organic light emitting layer 13 to be reflected by a reflective electrode 14. Herein, the reflective electrode 14 has irregularities and therefore the outside light L1 is diffused and reflected by this at various angles. These reflected lights are further diffused when passing through a boundary between the organic light emitting layer 13 and the transparent electrode 12 and through an irregularity surface 11 of the transparent layer 10, and outgo from the transparent substrate 9 toward a liquid crystal panel. On the other hand, lights L2 to L4 emitted from the organic light emitting layer 13 are diffused when passing through the boundary between the organic light emitting layer 13 and the transparent electrode 12 and through the irregularity surface 11 of the transparent layer 10, and outgo from the transparent substrate 9 toward the liquid crystal panel.

## Description

### [Technical Field]

The present invention relates to an EL (electroluminescence) device, and more particularly to an EL device used for a backlight of a liquid crystal display device.

The present invention also relates to a method of manufacturing such an EL device and a liquid crystal display device using the EL device.

### [Background Art]

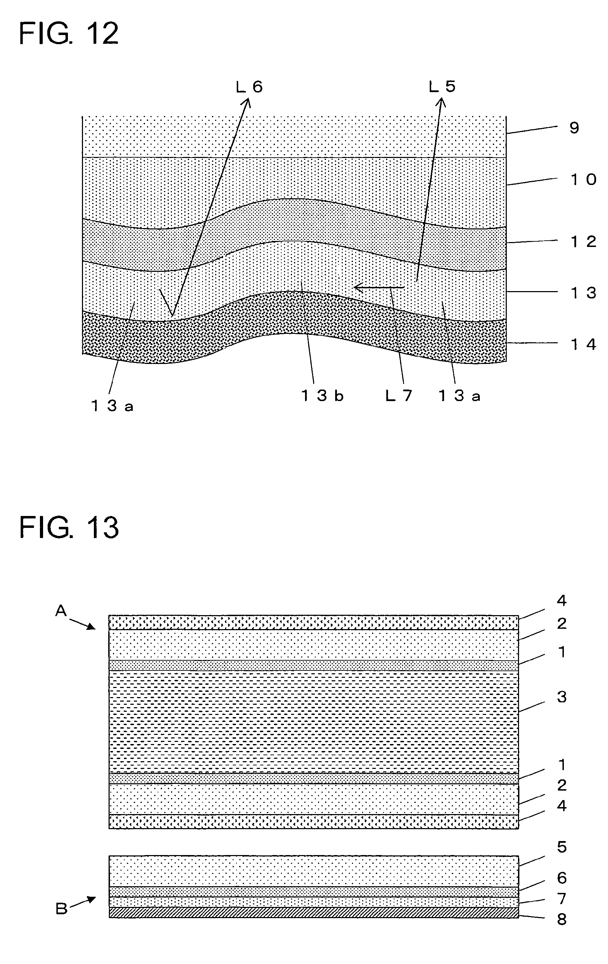

Heretofore, EL devices such as an inorganic EL device and an organic EL device have been used for displays and illumination devices. For example, among EL devices used for illumination devices, as shown in Fig. 13, there is an organic EL device B disposed at the rear of a liquid crystal panel A as a backlight and constituting a liquid crystal display device.

The liquid crystal panel A includes a pair of glass substrates 2 disposed in parallel and having transparent electrodes 1 on surfaces facing each other. Liquid crystal is sealed between the pair of glass substrates 2 to form a liquid crystal layer 3. Disposed on outer sides of the pair of glass substrates 2 are deflecting plates 4 . Whereas the organic EL device B includes a transparent substrate 5. And, a transparent electrode 6, an organic light emitting layer 7, and a reflective electrode 8 are layered sequentially on the transparent substrate 5. Light emitted from the organic light emitting layer 7 of the organic EL device B passes through the transparent electrode 6 and the transparent substrate 5 as illumination light to enter the rear surface of the liquid crystal panel A from the organic EL device B, and display light in accordance with the orientation state of the liquid crystal layer 3 outgoes from the front surface of the liquid crystal panel A, whereby display is conducted.

In this liquid crystal display device, when the surrounding is dark as in a night time, the organic light emitting layer 7 of the organic EL device B is controlled to emit light for illumination. In contrast, in the case where the surrounding is sufficiently bright as in a day time, outside light is taken in from the front surface of the liquid crystal panel A to be reflected by the reflective electrode 8 of the organic EL device B, and this can be utilized as the illumination light.

However, in the liquid crystal display device described above, the reflective electrode 8 of the organic EL device B has a smooth surface, which reflects the incoming outside light like a mirror surface. Therefore, the intensity of the reflected light is increased in a certain direction in accordance with the direction of the outside light, the illumination becomes uneven, and the visual field angle of the liquid crystal panel A narrows.

In view of the above, for example, in a liquid crystal display device disclosed in JP 9-50031 A, a diffusion plate is arranged between the liquid crystal panel and the organic EL device. This diffusion plate allows uniform illumination and widening of the visual field angle of the liquid crystal panel through diffusion of the illumination light from the organic EL device.

However, when the diffusion plate is separately arranged between the liquid crystal panel and the organic EL device, the number of components increases, and the overall structure of the liquid crystal display device becomes complicated. In addition, there is a problem in that when the illumination light passes through the diffusion plate, the illumination light attenuates.

Further, the EL device is required to attain the following aspects.
- Luminance Enhancement (Light Emission Amount Increase, Light Taking-out Efficiency Improvement)
   In other words, it is required that the amount of light emission per unit area increase, or the amount of light to be taken out toward the outside of the device increase. It is because, in particular, with such an EL device of a bottom emission type as shown in Fig. 13 in which the light emitted from the light emitting layer outgoes through the substrate (transparent substrate) toward the outside, the amount of light capable of outgoing from the substrate toward the outside is limited.
- Directional Characteristics Improvement of Outgoing Light (Light Use Efficiency Improvement)
   In other words, the EL device is required to emit a light whose amount is increased in a certain direction. For example, the organic EL device B shown in Fig. 13 is required to emit a larger amount of light which enters the deflecting plates 4 of the liquid crystal panel A at an incident angle of 0°. This is because light which does not enter the liquid crystal panel A or which enters the liquid crystal panel A but does not outgo from the panel cannot be utilized for the liquid crystal display device.
- Chromaticity Characteristics Improvement Depending On Light Outgoing Direction
   In other words, it is required to provide an EL device having substantially no difference in chromaticity depending on light outgoing directions.

### [Disclosure of the Invention]

The present invention has been made in view of the above problems and requirements, a first object of the present invention is to provide an EL device capable of avoiding light attenuation due to the use of a diffusion plate and diffusing the light sufficiently to conduct uniform illumination while having a simple structure.

A second object of the present invention is to provide an EL device which attains a large light emission amount.

A third object of the present invention is to provide an EL device which attains high light taking-out efficiency.

A fourth object of the present invention is to provide an EL device which attains high luminance in a certain direction.

A fifth object of the present invention is to provide an EL device in which a difference in chromaticity depending on outgoing directions is small.

The present invention is also intended to provide a manufacturing method with which such an EL device can be obtained and a liquid crystal display device using such an EL device.

According to the present invention, there is provided an EL device, including: a substrate; an intermediate layer formed on a surface of the substrate and having irregularities formed on a surface opposite to a surface which is in contact with the substrate; a first electrode layer formed on the intermediate layer; a light emitting layer formed on the first electrode layer; and a second electrode layer formed on the light emitting layer, at least one of the layers formed on the surface of the intermediate layer which has the irregularities thereon extending along a surface of the layer which is in contact with the at least one of the layers on a side of the intermediate layer.

The at least one of the layers can be formed in a substantially uniform thickness.

Furthermore, at least one of the layers preferably has a curved shape conforming to a surface of the intermediate layer on which irregularities are formed. As at least one of the layers has such a curved shape, a layer formed on the layer may have irregularities. Examples of the curved shape include a shape which is substantially parallel to the irregularities on the surface of the intermediate layer and has a uniform thickness, a shape having a concave portion formed thicker than a convex portion, and a shape having a convex portion formed thicker than a concave portion.

The light emitting layer preferably has a curved shape conforming to the surface of the intermediate layer on which the irregularities are formed.

It is preferable that, among the first electrode layer and the second electrode layer disposed on both sides of the light emitting layer, one electrode layer opposite to a light taking-out side with respect to the light emitting layer is formed of a reflective electrode and the other electrode layer is formed of a transparent electrode, and that the reflective electrode has a curved shape conforming to the surface of the intermediate layer on which the irregularities are formed.

The intermediate layer can be formed of a photoresist or a sheet previously provided with an irregularity shape on its surface and affixed onto the substrate.

In addition, the surface of the intermediate layer on which the irregularities are formed is preferably an irregularity surface on which a concave portion and a convex portion are formed at random.

It is preferable that at least one prism sheet is further disposed on a light taking-out side with respect to the light emitting layer. A sheet having a plurality of linear convex portions which are disposed in parallel to each other, and each of which is sharply pointed to have a triangular shape in cross section, can be used as the prism sheet. In this case, two prism sheets are preferably overlapped and disposed so that extending directions of the linear convex portions intersect each other.

According to the present invention, there is provided a method of manufacturing an EL device, including: forming on a surface of a substrate an intermediate layer having a surface on which irregularities are formed; forming a first electrode layer on the intermediate layer; forming a light emitting layer on the first electrode layer; and forming a second electrode layer on the light emitting layer, at least one of the layers formed on the surface of the intermediate layer which has the irregularities thereon extending along a surface of the layer which is in contact with the at least one of the layers on a side of the intermediate layer.

In addition, one of the first electrode layer and the second electrode layer opposite to a light taking-out side with respect to the light emitting layer is formed of a reflective electrode and the other is formed of a transparent electrode, and a surface of the reflective electrode has a curved shape conforming to the surface of the intermediate layer on which the irregularities are formed, whereby light is diffused and reflected by the surface of the reflective electrode.

Furthermore, it is desirable that the at least one of the layers includes the light emitting layer.

A liquid crystal display device according to the present invention uses the above-described EL device according to the present invention for a backlight.

### [Brief Description of the Drawings]

Fig. 1 is a cross sectional view showing a structure of a liquid crystal display device according to Embodiment 1 of the present invention;
Fig. 2 is a diagram showing how light is reflected and diffused in an organic EL device in Embodiment 1;
Fig. 3 is a graph showing visual field angle characteristics of the organic EL device in Embodiment 1;
Fig. 4A and Fig. 4B, and Fig. 4C are cross sectional views showing, in a stepwise manner, a method of manufacturing the organic EL device in Embodiment 1, respectively;
Fig. 5 is a cross sectional view showing an organic EL device according to Embodiment 2 of the present invention;
Fig. 6 is an enlarged perspective view showing one prism sheet in Embodiment 2;
Fig. 7 is a cross sectional view showing an organic EL device according to a modification example of Embodiment 2;
Fig. 8 is an enlarged perspective view showing two prism sheets used in the modification example of Embodiment 2;
Fig. 9 is a graph showing a rate of increase in frontal luminance of the organic EL device in Embodiment 2;
Figs. 10 and 11 are each a graph showing the amount of the change in chromaticity coordinates x and y depending on the outgoing angle of the organic EL device in Embodiment 2;
Fig. 12 is a view showing a state of light emitted from a concave portion and a convex portion of an organic light emitting layer in Embodiment 1; and
Fig. 13 is a cross sectional view showing a structure of a conventional liquid crystal display device.

### [Best Mode for carrying out the Invention]

Hereinafter, embodiments of the present invention will be described with reference to the accompanying drawings. Embodiment 1

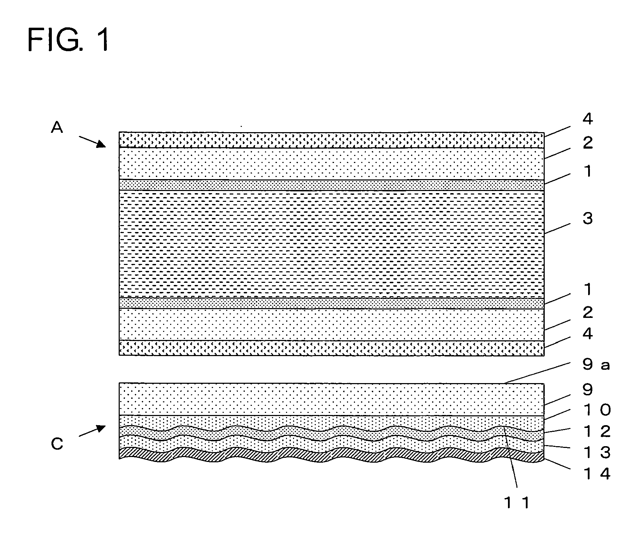

Fig. 1 shows a cross section of a liquid crystal display device according to Embodiment 1. This liquid crystal display device has a liquid crystal panel A and an organic EL device C disposed at the rear of the liquid crystal panel A as a backlight. The liquid crystal panel A includes a pair of glass substrates 2 disposed in parallel and having transparent electrodes 1 on the surfaces facing each other. Liquid crystal is sealed between the pair of glass substrates 2 to form a liquid crystal layer 3. Further, disposed on outer sides of the pair of glass substrates 2 are deflecting plates 4.

On the other hand, the organic EL device C includes a planar transparent substrate 9, and formed on this transparent substrate 9 is a transparent layer 10 constituting an intermediate layer of the present invention. The transparent layer 10 has an irregularity surface 11 on which a concave portion and a convex portion are formed at random on a surface thereof opposite to the transparent substrate 9. A transparent electrode 12 is formed on and along the irregularity surface 11 of this transparent layer 10, an organic light emitting layer 13 is formed on and along the surface of the transparent electrode 12, and a reflective electrode 14 is further formed on and along the surface of the organic light emitting layer 13. For this reason, the transparent electrode 12, the organic light emitting layer 13, and the reflective electrode 14 each have irregularities. The transparent electrode 12, the organic light emitting layer 13, and the reflective electrode 14 each have a uniform thickness and therefore have a curved shape conforming to the irregularity surface 11 of the transparent layer 10. The transparent electrode 12 and the reflective electrode 14 constitute a first electrode layer and a second electrode layer of the present invention, respectively. Note that, in this organic EL device C, a main surface of the transparent substrate 9 on the liquid crystal panel A side serves as an outgoing surface 9a for light. In other words, the transparent electrode 12, the transparent layer 10, and the transparent substrate 9 are disposed on the light taking-out side with respect to the organic light emitting layer 13 and have transparency to light (visible light, in general) taken out toward the outside of the EL device C, and the reflective electrode 14 is a layer on a side opposite to the light taking-out side with respect to the organic light emitting layer 13.

In this liquid crystal display device, the organic light emitting layer 13 of the organic EL device C is caused to emit light which is used as illumination light. Whereas in the case where the surrounding is sufficiently bright as in a day time, outside light passing through the liquid crystal panel A and entering the organic EL device C is reflected by the reflective electrode 14, and the resultant light can also be used as the illumination light. Those illumination lights enter the rear surface of the liquid crystal panel A, and display light in accordance with the orientation state of the liquid crystal layer 3 outgoes from the front surface of the liquid crystal panel A, thereby carrying out the display.

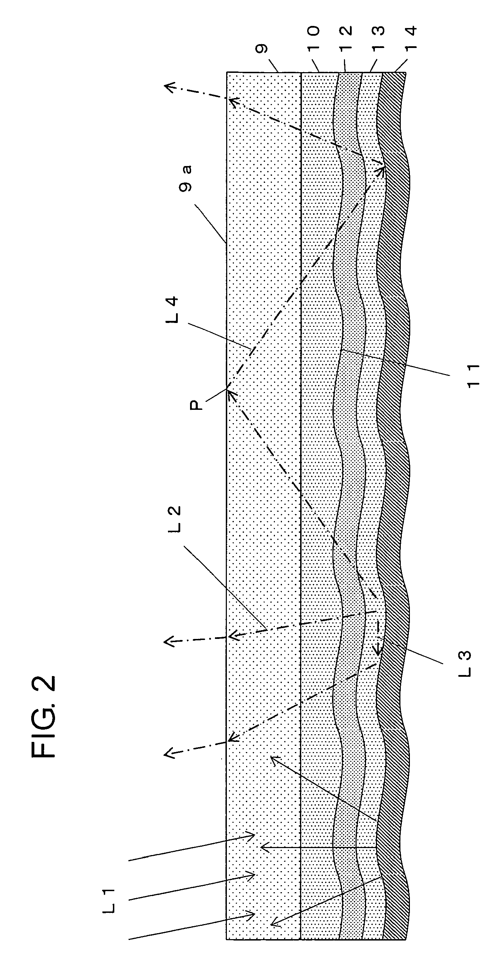

Herein, as shown in Fig. 2, outside lights L1 entering the transparent substrate 9 of the organic EL device C and passing through this substrate 9 then pass through the transparent layer 10, the transparent electrode 12, and the organic light emitting layer 13 to be reflected by the reflective electrode 14. At this time, the outside lights L1 are diffused there and reflected at various angles because the reflective electrode 14 has a curved shape. When passing through a boundary between the organic light emitting layer 13 and the transparent electrode 12 and through the irregularity surface 11 of the transparent layer 10, those reflected lights are further diffused owing to the refractive index difference. Further, when passing through a boundary between the transparent layer 10 and the transparent substrate 9, the lights are refracted owing to the refractive index difference. After that, the resultant lights outgo from the light outgoing surface 9a of the transparent substrate 9 toward the liquid crystal panel A. With this configuration, it is possible to obtain the uniform illumination light, and the conventional mirror reflection can be prevented. In addition, the diffused lights outgo from the front surface of the liquid crystal panel A at various angles, thereby making it possible to widely secure the visual field angle of the liquid crystal panel A.

Further, the reflective electrode 14 has a curved shape corresponding to the irregularity surface 11 so that a reflected image thereon is also diffused and reflected. Therefore, a double vision composed of an image displayed by the liquid crystal panel A and an image reflected on the reflective electrode, which is so-called double image formed as in the prior art, is hardly observed.

Hence, unlike in the prior art, it is unnecessary to arrange a diffusion plate independently, so attenuation of the outgoing light caused when the light passes through the diffusion plate can be eliminated.

On the other hand, when passing through the boundary between the organic light emitting layer 13 and the transparent electrode 12 and through the irregularity surface 11 of the transparent layer 10, a light L2 emitted from the organic light emitting layer 13 of the organic EL device C is diffused owing to the refractive index difference. Further, when passing through the boundary between the transparent layer 10 and the transparent substrate 9, the light L2 is refracted owing to the refractive index difference. After that, the resultant light outgoes from the light outgoing surface 9a of the transparent substrate 9 toward the liquid crystal panel A. With this configuration, a part of the light which could not outgo from the inside of the layer toward the outside in a conventional flat light emitting layer can now be allowed to outgo therefrom.

In addition, since the organic light emitting layer 13 has a curved shape, among the lights emitted from the organic light emitting layer 13, a part of a light L3 emitted in substantially parallel with respect to the transparent substrate 9 is reflected by the reflective electrode 14, and the reflected light passes through the organic light emitting layer 13, the transparent electrode 12, and the transparent layer 10 to outgo from the light outgoing surface 9a of the transparent substrate 9 toward the liquid crystal panel A.

Furthermore, among the lights emitted from the organic light emitting layer 13, a light L4 totally reflected at a point P of the light outgoing surface 9a of the transparent substrate 9 passes through the transparent layer 10, the transparent electrode 12, and the organic light emitting layer 13 and reaches the reflective electrode 14 to be reflected by this reflective electrode 14. As the reflective electrode 14 has the irregularities, the angle with respect to the light outgoing surface 9a of the transparent substrate 9 varies at the time of the reflection. As a result, the light L4 totally reflected by the light outgoing surface 9a and returning to the inside of the organic EL device C is also likely to finally outgo from the light outgoing surface 9a of the transparent substrate 9 toward the liquid crystal panel A.

In this way, each of the reflected light of the light L3 emitted substantially in parallel with respect to the transparent substrate 9 and the reflected light of the light L4 totally reflected by the light outgoing surface 9a of the transparent substrate 9 can be utilized as the illumination light, whereby it is possible to provide an organic EL device with high light taking-out efficiency.

In addition, the irregularities formed on the transparent layer 10, the transparent electrode 12, the organic light emitting layer 13, and the reflective electrode 14 are each allowed to have the light condensing function of a micro lens or the like by selecting the shape of the irregularities.

In this organic EL device C, an existing planar transparent substrate can be employed because the transparent layer 10 having the irregularity surface 11 is independently formed on the transparent substrate 9. Further, the degree of freedom in selecting a material of the transparent layer 10 increases. Therefore, when such a material of the transparent layer 10 is appropriately selected that the refractive index difference with the transparent substrate 9, or the refractive index difference with the transparent electrode 12, etc. becomes a predetermined value, desired diffusion characteristics for the irregularity surface 11 can be easily attained, and it becomes possible to change the degree of the diffusion effect freely. In addition, such a material as to easily process and form the irregularity surface 11 is selected for the transparent layer 10, making it possible to manufacture the EL device of the present invention with high yield.

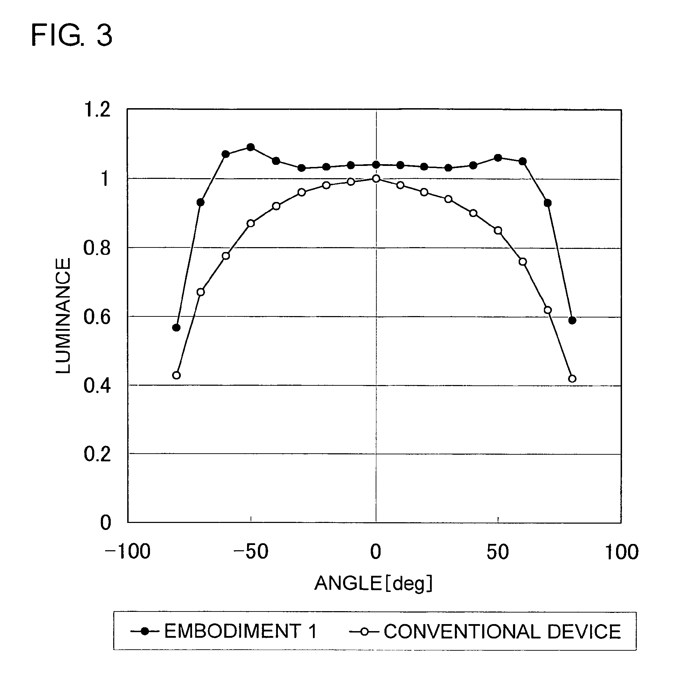

Fig. 3 shows the luminance characteristics with respect to the visual field angle upon light emission regarding the organic EL device C according to Embodiment 1 and the conventional organic EL device B shown in Fig. 13. In this graph, the luminance in the normal direction on the light outgoing surface of the conventional organic EL device B is set as the reference, and the magnitude of luminance is represented in terms of ratio to this reference. Further, each of the organic EL devices was manufactured with the same material, the same thickness, and the same manufacturing method, except that the transparent layer 10 provided with the irregularity surface 11 was arranged on the transparent substrate 9 of the device C.

As is understood from this graph, the organic EL device C of Embodiment 1 has high luminance over the entirety of the wide visual field angle as compared to the conventional organic EL device B, and the visual field angle is widened. Among the lights emitted from the flat organic light emitting layer 7 of the conventional organic EL device B, the light entering the front surface of the transparent substrate 5, i.e., the light outgoing surface, at a critical angle or larger, is repeatedly reflected between this light outgoing surface and the reflective electrode 8, and is likely to be trapped inside the organic EL device B. Therefore, as the visual field angle increases, the amount of the outgoing light decreases. In contrast to this, among the lights emitted from the organic light emitting layer 13 of the organic EL device C according to Embodiment 1, even when the light entering the light outgoing surface 9a of the transparent substrate 9 at the critical angle or larger is totally reflected by the light outgoing surface 9a, the angle to the light outgoing surface 9a varies when the light is reflected by the reflective electrode 14 having the curved shape as mentioned above, thus facilitating the light to outgo from the organic EL device C. Therefore, it is conceivable that the overall luminance increases, and that the amount of the light outgoing toward an oblique direction increases in particular.

In addition, it is found that in the organic EL device C, the luminance in a specific direction (about 50° with respect to the normal direction of the light outgoing surface) increases. It should be noted that this specific direction can be changed by appropriately designing the shape of the irregularities.

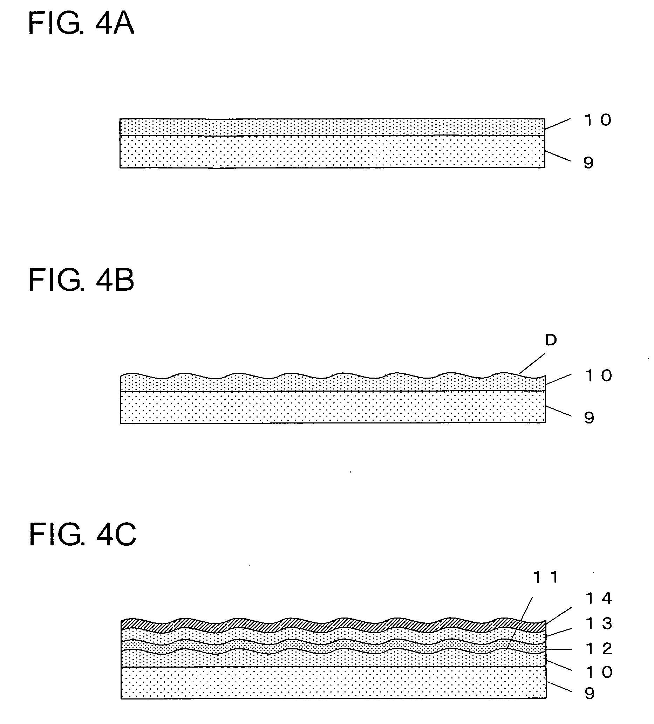

Next, a description will be given to a method of manufacturing the organic EL device C described above. As shown in Fig. 4A, the transparent layer 10 is formed in a predetermined thickness on the surface of the planar transparent substrate 9. On the surface of this transparent layer 10, a patterning is conducted by photoresist or the like with a mask having a pattern corresponding to the arrangement of a concave portion and a convex portion to be formed by etching, the irregularity surface 11 as shown in Fig. 4B is formed by carrying out the etching in this state.

Then, as shown in Fig. 4C, sequentially in a uniform thickness, the transparent electrode 12 is formed on the irregularity surface 11 of the transparent layer 10, the organic light emitting layer 13 is formed on the transparent electrode 12, and further the reflective electrode 14 is formed on the organic light emitting layer 13. The transparent electrode 12, the organic light emitting layer 13, and the reflective electrode 14 are each so formed as to have irregularities on the surface thereof which is in contact with the layer on the transparent layer 10 side. Each layer is formed in a uniform thickness, and therefore has a curved shape conforming to the irregularity surface 11 of the transparent layer 10. In this way, the organic EL device C shown in Fig. 1 is manufactured.

Note that, a method of forming an intermediate layer using half-exposure and focus offset through photolithography may be adopted instead of the above etching method. That is, a photoresist may be used as the intermediate layer.

Also, the irregularity surface 11 of the transparent layer 10 can also be formed by surface processing under sandblast or the like instead of the etching.

Further, the intermediate layer may be obtained by attaching a sheet which is made of transparent resin or the like and has irregularities previously formed on the surface thereof onto the transparent substrate 9. Also, instead of forming the irregularities on the surface of the transparent layer 10 formed on the transparent electrode 9 in a uniform thickness, the irregularity surface may also be obtained by forming a first transparent film on only a part of the transparent substrate 9 where a convex portion is to be formed, and then forming a second transparent film over the entire surface of this first transparent film and the transparent substrate 9.

Further, a known material and forming method can be employed as the material for each of layers and the methods of forming the respective layers, and so forth, in the liquid crystal panel A and the organic EL device C. For example, the transparent substrate 9 of the organic EL device C may be formed by a transparent or translucent material to the visible light such as glass or resin meeting such conditions. It suffices that the transparent electrode 12 has a function of an electrode and is transparent or translucent to the visible light, for instance, ITO is adopted for its material. The material for the organic light emitting layer 13 contains at least a known organic light emitting material such as Alq₃ or DCM. In addition, one or plural layers such as an electron transport layer and a hole transport layer adopted in a known organic EL device may be formed between the electrodes arbitrarily, and each layer may be appropriately formed of a known material. It suffices that the reflective electrode 14 has a function of an electrode and is reflective to the visible light, for example, Al, Cr, Mo, an Al alloy, an Al/Mo laminate, or the like can be adopted. The respective layers may be formed by a known thin film formation method such as a vacuum evaporation method.

### Embodiment 2

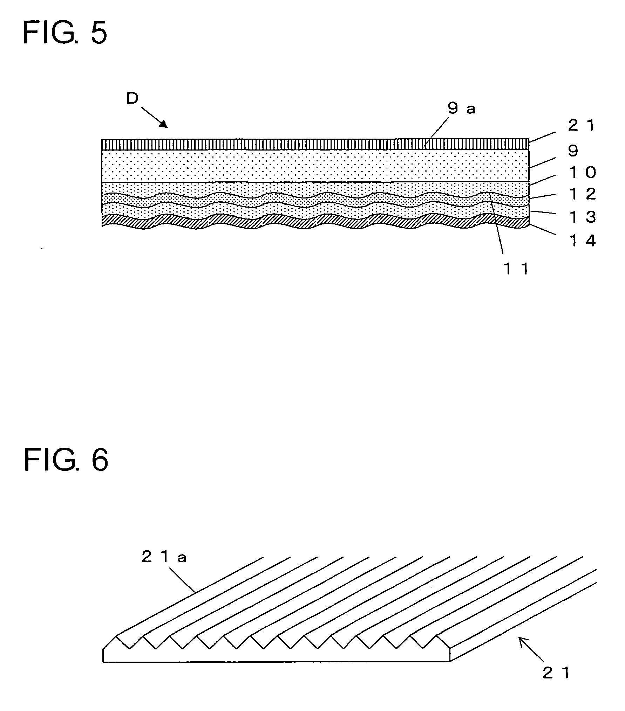

Fig. 5 shows a cross section of an organic EL device D according to Embodiment 2. The organic EL device D of Embodiment 2 is obtained by arranging one prism sheet 21 on the light outgoing surface 9a of the transparent substrate 9 of the organic EL device C in Embodiment 1. The prism sheet 21 herein has a plurality of linear convex portions 21a formed in parallel to each other as shown in Fig. 6. Each of the linear convex portions 21a is sharply pointed to have a triangular shape in cross section. This prism sheet 21 is arranged on the light outgoing surface 9a of the transparent substrate 9, therefore the direction of light emitted from the light outgoing surface 9a is refracted according to the shape of the linear convex portions 21a (the angle with respect to the light outgoing surface 9a having a triangular shape in cross section), and the refractive index of the prism sheet 21. For instance, when a prism sheet for refracting the light having an incident angle of about 50° in the normal direction of the light outgoing surface 9a is used, it is possible to provide the organic EL device having the outgoing characteristics shown in Fig. 3 with higher luminance in the normal direction of the light outgoing surface 9a than that of other directions.

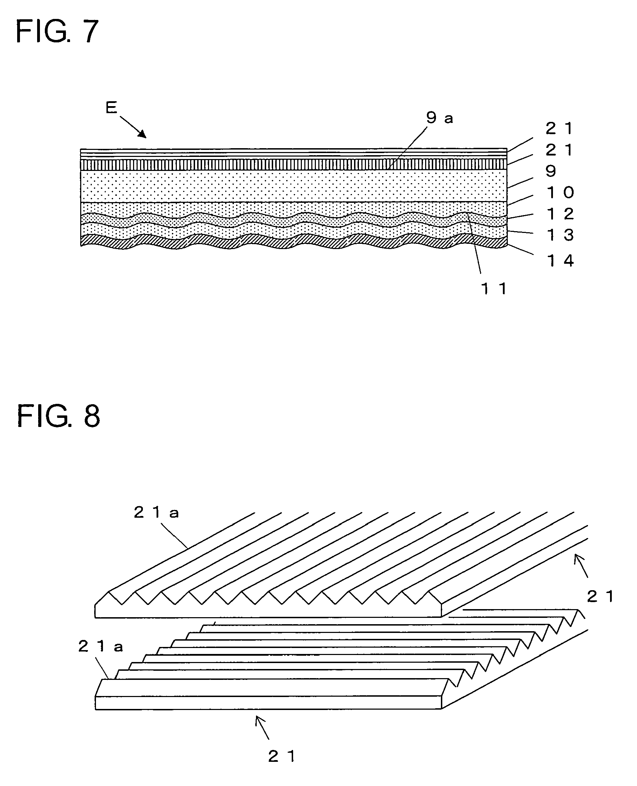

In addition, as in an organic EL device E shown in Fig. 7, two prism sheets 21 may be laminated and disposed on the light outgoing surface 9a of the transparent substrate 9. In that case, the two prism sheets 21 are disposed so that the extending directions of the linear convex portions 21a intersect each other as shown in Fig. 8. With this configuration, larger amount of light can be made into light traveling in the normal direction of the light outgoing surface 9a.

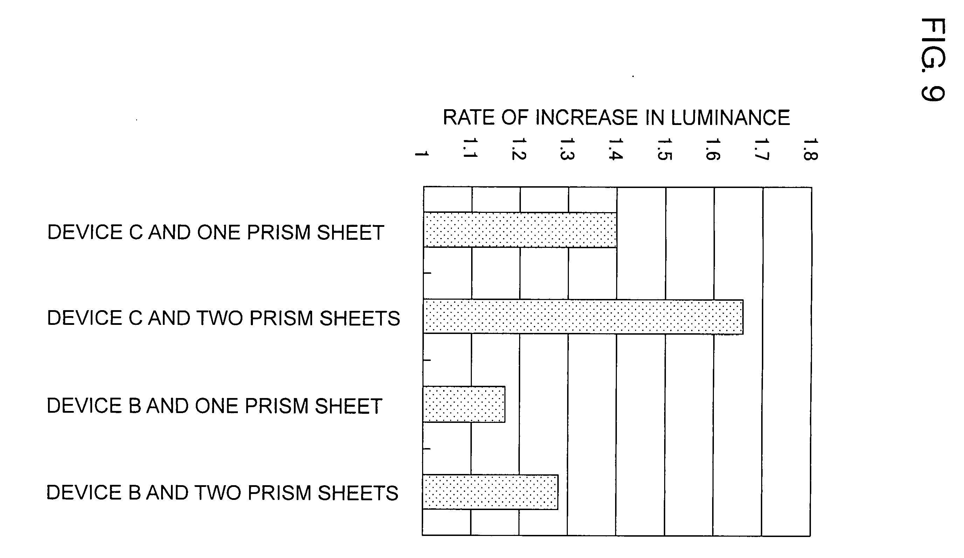

Now, measurement for the rate of increase in frontal luminance was conducted on the organic EL device D (the organic EL device C and one prism sheet) and the organic EL device E (the organic EL device C and two prism sheets) in Embodiment 2 with respect to that of the organic EL device C, and was conducted on devices obtained by respectively providing on the light outgoing surface of the transparent substrate 5 of the conventional organic EL device B shown in Fig. 13 with one prism sheet 21 (the organic EL device B and one prism sheet) and two prism sheets 21 (the organic EL device B and two prism sheets) with respect to that of the organic EL device B. Results shown in Fig. 9 were obtained.

The rate of increase in luminance was 1.17 times when the conventional organic EL device B was provided with the one prism sheet 21 and 1.28 times when the conventional organic EL device B was provided with the two prism sheets 21. In contrast to this, the rate of increase in luminance was 1.4 times when the organic EL device C was provided with the one prism sheet 21 (the organic EL device D) and 1. 66 times when the organic EL device C was provided with the two prism sheets (the organic EL device E) . To summarize, the organic EL device C has the larger rate of increase in frontal luminance than the conventional organic EL device B due to the provision of the prism sheet 21. The reason for this is probably as follows. As described above, the amount of light outgoing in an oblique direction in the organic EL device C is increased more than that in the conventional organic EL device B, and this light which outgoes in an oblique direction is condensed by the linear convex portions 21a of the prism sheet 21. As a result, the amount of light from the light outgoing surface in a perpendicular direction increases. In addition, in both cases of the organic EL device B and the organic EL device C, providing the two prism sheets 21 makes the rate of increase in frontal luminance larger than providing the one prism sheet 21. This is because of the following reason. As shown in Fig. 6, in the prism sheets 21 having the plural linear convex portions 21a formed in parallel to each other, the condensing function is effected only in the width direction of the respective linear convex portions 21a. Therefore, by arranging the two prism sheets 21 so that the extending directions of the linear convex portions 21a intersect each other, the condensing function is effected in the width direction of the respective linear convex portions 21a of the two prism sheets 21, and as a result, the rate of increase in frontal luminance in this case is larger than that in the case of using the one prism sheet 21.

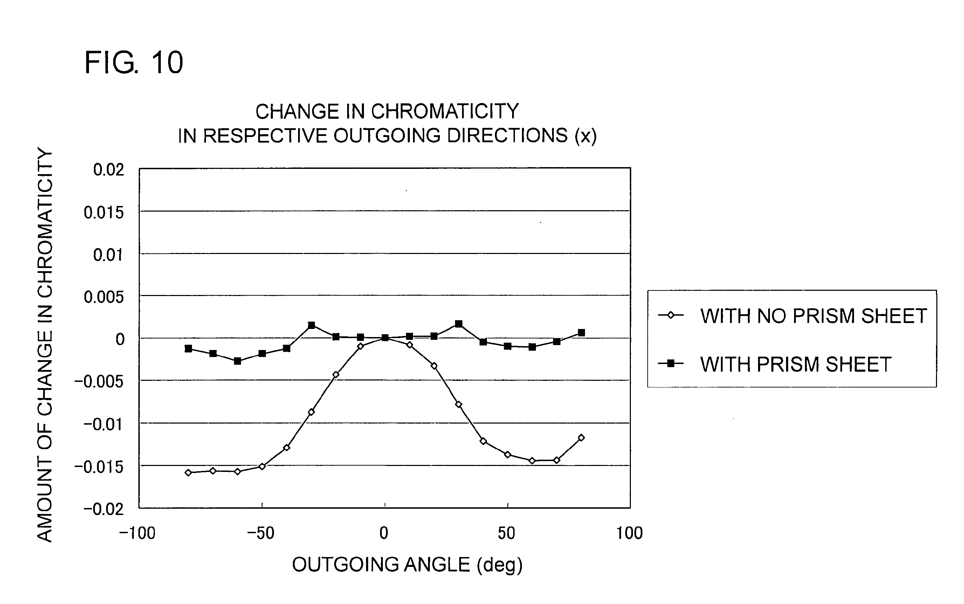

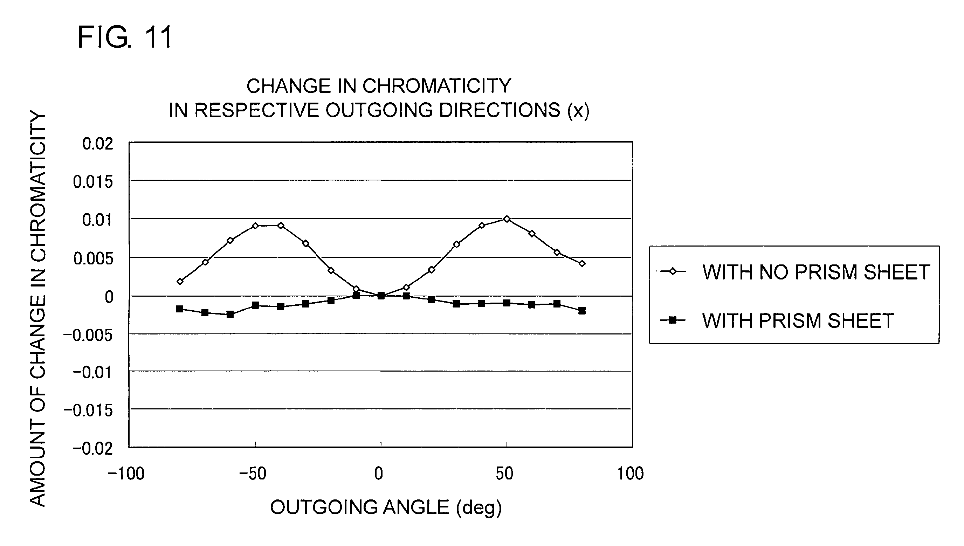

Then, measurement was conducted on the case of disposing no prism sheets 21 (the organic EL device C) and the case of disposing the prism sheet 21 on the light outgoing surface 9a of the organic EL device C (the organic EL device D) for the change in chromaticity coordinates x and y in the respective outgoing directions with the normal of the light outgoing surface 9a as the reference. The results shown in Fig. 10 and Fig. 11 were obtained.

Those results show that even in the case of disposing no prism sheets 21 (the organic EL device C), the amount of change in chromaticity coordinates x and y in the respective outgoing directions is sufficiently small, and the chromaticity characteristics are improved as compared to those of the conventional organic EL device. The reason why the chromaticity characteristics are improved in this way is probably that the organic EL device C has irregularity surface and thus takes out a larger amount of light having a wavelength with a small critical angle as compared with the conventional organic EL device.

In addition, it was found that when the prism sheet 21 was disposed on the light outgoing surface 9a of the organic EL device C (the organic EL device D), the amount of change in chromaticity coordinates x and y in the respective outgoing directions was still smaller, therefore making it possible to achieve further uniform chromaticity. When two prism sheets 21 are laminated and disposed while intersecting each other, the light with still more uniform color will be obtained.

In this way, the organic EL device D and the organic EL device E have the improved chromaticity characteristics as compared to the conventional device. Further, by disposing one or two of prism sheets on the light outgoing surface 9a of the transparent substrate 9 in the organic EL device C, the light outgoing from the organic EL device C in an oblique direction is utilized to achieve the uniform chromaticity as well as the enhancement in frontal luminance.

Note that, each of the organic EL device D and the organic EL device E according to Embodiment 2 can be used for the backlight of the liquid crystal display device similarly to the organic EL device C according to Embodiment 1.

It is also possible to use various types of prism sheets such as a prism sheet having convex portions or v-shaped grooves formed in lattice on its surface and a prism sheet having convex portions formed concentrically thereon instead of the prism sheets 21 (luminance enhancement films) having the linear convex portions 21a formed parallel to each other.

It should be noted that in Embodiments 1 and 2 described above, although a concave portion and a convex portion are formed at random on the irregularity surface 11 of the transparent layer 10, an irregularity surface having a plurality of concave portions and convex portions formed with regularity thereon may be used. However, the random irregularity surface 11 allows the transparent electrode 12 and the reflective electrode 14 to have random irregularities formed thereon. As a result, the refracted light through the transparent electrode 12 and the reflected lights by the reflective electrode 14 travel in various directions, thereby attaining still higher diffusion effect. Also, when the random irregularities are provided, the probability of taking out the lights traveling in diverse directions from the organic light emitting layer 13 becomes higher.

Further although in Fig. 1, plural concave portions and convex portions are alternatively and continuously formed over the entire surface of the transparent layer 10, the irregularities may be formed on a part of the surface of the transparent layer 10. With this configuration, each of the transparent electrode 12, the organic light emitting layer 13, and the reflective electrode 14 has the irregularities on a part of its surface, and the similar effect such as the diffusion effect described above can be obtained. Moreover, instead of a plurality of irregularities, only one irregularity, that is, one concave portion and one convex portion may be formed thereon. In addition, even when a concave portion alone or a convex portion alone is formed on the surface of the planar transparent layer 10, and the transparent electrode 12, the organic light emitting layer 13, and the reflective electrode 14 are sequentially formed over this surface, it is possible to attain the similar effect such as the diffusion effect described above.

Herein, as shown in Fig. 12, among the lights emitted from a concave portion 13a of the organic light emitting layer 13 having a curved shape, a main part of a light L5 emitted toward the transparent electrode 12 direction passes through the transparent electrode 12, the transparent layer 10, and the transparent substrate 9 to outgo from the light outgoing surface, and a light L6 emitted toward the reflective electrode 14 direction is reflected by the reflective electrode 14, and thereafter passes through the transparent electrode 12, the transparent layer 10, and the transparent substrate 9 to outgo from the light outgoing surface. Further, a light L7 emitted in parallel to the transparent substrate 9 from the concave portion 13a of the organic light emitting layer 13 is also reflected by the reflective electrode 14 and passes through the transparent electrode 12, the transparent layer 10, and the transparent substrate 9 to outgo from the light outgoing surface.

In contrast to this, a convex portion 13b of the organic light emitting layer 13 is positioned so that its boundary surface with the transparent electrode 12 is covered. Therefore, even if light emission from the convex portion 13b is caused, as compared to the case of the light emission from the concave portion 13a, the amount of light reflected by its boundary surface with the transparent electrode 12 and trapped inside the organic light emitting layer 13 increases. In other words, it is difficult to efficiently take out the light emitted from the convex portion 13b of the organic light emitting layer 13, which is elevated with respect to the light outgoing surface.

In view of the above, when the area occupied by the concave portion where the light taking-out efficiency is high is set large with respect to the entire surface of the organic light emitting layer 13, the improvement of light taking-out efficiency is achieved in overall. In this manner, it is preferred to form such an irregularity surface 11 in which the occupying area of the concave portion of the organic light emitting layer 13 is large on the surface of the transparent layer 10. It becomes also possible to set the luminance in a certain direction high depending on the condensing characteristics of the concave portion.

Similarly, by adjusting the shape, number, size, distance, etc., of the irregularities formed on the surface of the transparent layer 10, the degree of the diffusion effect and the light taking-out efficiency can be changed.

Further, although in Embodiments 1 and 2, each layer of the transparent electrode 12, the organic light emitting layer 13, and the reflective electrode 14 formed on the irregularity surface 11 of the transparent layer 10 has the irregularities, when at least one layer of the respective layers has irregularities, the light can be diffused at the boundary of the layer. In this regard, if irregularities are formed on the reflective electrode 14, a larger diffusion effect can be attained because the lights are diffused and reflected by the reflective electrode 14 to be refracted by a boundary of other layers in various directions.

In addition, in Embodiments 1 and 2 described above, each of the transparent electrode 12, the organic light emitting layer 13, and the reflective electrode 14 is formed to have a shape having a uniform thickness and substantially parallel to the irregularity surface 11 of the transparent layer 10. However, instead of providing each of the layers with shapes similar to each other, an arbitrary layer may have a shape in which a concave portion is formed thicker than a convex portion or a shape in which a convex portion is formed thicker than a concave portion. With such configuration, the respective layers have the shapes different from each other and have different refraction directions by the boundaries, resulting in the improvement in diffusion effect.

Described in Embodiments 1 and 2 is the organic EL device of a bottom emission type where the transparent layer 10, the transparent electrode 12, the organic light emitting layer 13, and the reflective electrode 14 are sequentially layered on the transparent substrate 9 and the light emitted from the organic light emitting layer 13 passes through the transparent electrode 12, the transparent layer 10, and the transparent substrate 9 to outgo. The present invention, however, is not limited to this but is applicable to an organic EL device of a top emission type where an intermediate layer, a reflective electrode, an organic light emitting layer, and a transparent electrode are sequentially layered on a substrate and the light emitted from the organic light emitting layer passes through the transparent electrode opposite to the substrate to outgo. In this top emission type, the reflective electrode and the transparent electrode function as the first electrode layer and the second electrode layer of the present invention, respectively, and it does not matter whether or not the substrate and the intermediate layer are transparent to the visible light. Also, a surface of the transparent electrode opposite to the surface thereof in contact with the organic light emitting layer serves as the light outgoing surface. By disposing a prism sheet on this light outgoing surface, it is possible to enhance the frontal luminance as in Embodiment 2 described above. It should be noted that at this time a configuration may be taken in which a protective film made of an oxide film, a nitride film, or the like is formed on the light outgoing surface, and a prism sheet is formed on this protective film.

Note that, while the intermediate layer may be formed directly on the substrate, it may also be formed above the substrate via the other layer or layers.

While the organic EL device has been described above, the present invention can be applied to an inorganic EL device in a similar manner.

As described above, according to the present invention, it is possible to provide the EL device capable of avoiding the light attenuation due to the use of the diffusion plate and diffusing the light sufficiently to conduct the uniform illumination while having a simple structure.

According to the present invention, it is possible to provide the EL device which attains a large light emission amount.

According to the present invention, it is possible to provide the EL device which attains high light taking-out efficiency.

According to the present invention, it is possible to provide the EL device which attains high luminance in a certain direction.

According to the present invention, it is possible to provide the EL device in which a difference in chromaticity depending on the outgoing directions is small.

According to the present invention, it is possible to provide a manufacturing method with which such an EL device can be obtained and the liquid crystal display device using such an EL device.

## Claims

1. An EL device, comprising:
a substrate;
an intermediate layer formed on a surface of the substrate and having irregularities formed on a surface opposite to a surface which is in contact with the substrate;
a first electrode layer formed on the intermediate layer;
a light emitting layer formed on the first electrode layer; and
a second electrode layer formed on the light emitting layer,
at least one of the layers formed on the surface of the intermediate layer which has the irregularities thereon extending along a surface of the layer which is in contact with the at least one of the layers on a side of the intermediate layer.

2. An EL device according to claim 1, wherein the at least one of the layers is formed in a substantially uniform thickness.

3. An EL device according to claim 1, wherein the at least one of the layers has a curved shape conforming to the surface of the intermediate layer on which the irregularities are formed.

4. An EL device according to claim 1, wherein the light emitting layer has a curved shape conforming to the surface of the intermediate layer on which the irregularities are formed.

5. An EL device according to claim 1, wherein one of the first electrode layer and the second electrode layer opposite to a light taking-out side with respect to the light emitting layer is formed of a reflective electrode and the other is formed of a transparent electrode, and the reflective electrode has a curved shape conforming to the surface of the intermediate layer on which the irregularities are formed.

6. An EL device according to claim 1, wherein the intermediate layer is formed of a photoresist.

7. An EL device according to claim 1, wherein the intermediate layer is formed of a sheet previously provided with an irregularity shape on its surface and affixed onto the substrate.

8. An EL device according to claim 1, wherein the surface of the intermediate layer on which the irregularities are formed is an irregularity surface on which a concave portion and a convex portion are formed at random.

9. An EL device according to claim 1, further comprising at least one prism sheet disposed on a light taking-out side with respect to the light emitting layer.

10. An EL device according to claim 9, wherein the at least one prism sheet has a plurality of linear convex portions disposed in parallel to each other, each of the linear convex portions being sharply pointed to have a triangular shape in cross section.

11. An EL device according to claim 10, wherein two prism sheets are overlapped and disposed so that extending directions of the linear convex portions intersect each other.

12. A method of manufacturing an EL device, comprising:
forming on a surface of a substrate an intermediate layer having a surface on which irregularities are formed;
forming a first electrode layer on the intermediate layer;
forming a light emitting layer on the first electrode layer; and
forming a second electrode layer on the light emitting layer,
at least one of the layers formed on the surface of the intermediate layer on which has the irregularities thereon extending along a surface of the layer which is in contact with the at least one of the layers on a side of the intermediate layer.

13. A method of manufacturing an EL device according to claim 12, wherein one of the first electrode layer and the second electrode layer opposite to a light taking-out side with respect to the light emitting layer is formed of a reflective electrode, and the other is formed of a transparent electrode, and a surface of the reflective electrode has a curved shape conforming to the surface of the intermediate layer on which the irregularities are formed.

14. A method of manufacturing an EL device according to claim 12, wherein the at least one of the layers includes the light emitting layer.

15. A liquid crystal display device comprising the EL device according to claim 1 used for a backlight.
